# EUROPEAN PATENT SPECIFICATION

(11) **EP 0 290 501 B1**
(45) Date of publication and mention of the grant of the patent: **10.03.1993**
(21) Application number: 87906964.9
(22) Date of filing: 28.09.1987
(51) Int. Cl.: H01L 21/56, H01L 23/28, B29C 51/16

(54) **METHOD AND APPARATUS FOR PACKAGING INTEGRATED CIRCUIT CHIPS EMPLOYING A POLYMER FILM OVERLAY LAYER**
VERFAHREN UND APPARAT ZUM PACKEN INTEGRIERTER SCHALTUNGSCHIPS MIT EINER POLYMERFILM-BEDECKUNGSSCHICHT
PROCEDE ET DISPOSITIF D'EMBALLAGE DE PUCES A CIRCUIT INTEGRES UTILISANT UNE COUCHE DE COUVERTURE EN FILM POLYMERE

(30) Priority: 26.09.1986 US 912458
(43) Date of publication of application: 17.11.1988
(73) Proprietor: GENERAL ELECTRIC COMPANY, Schenectady New York 10022 (US)
(72) Inventor: EICHELBERGER, Charles, William, Schenectady, NY 12308 (US); WOJNAROWSKI, Robert, John, Ballston Lake, NY 12019 (US); WELLES, Kenneth, Brakeley, II, Schenectady, NY 12304 (US)
(74) Representative: Pratt, Richard Wilson
(86) International application number: US8702501
(87) International publication number: WO8802551

(56) References cited:
- DE-A- 2 210 475
- DE-A- 2 915 923
- US-A- 4 338 132
- Patent Abstracts of Japan, volume 8, no. 224 (M-331 )(1661), 13 October 1984 & JP, A, 59104 907
- Patent Abstracts of Japan, volume 9, no. 132 (M-385)(1855), 7 June 1985, & JP, A, 6015124 & JP, A, 6015124

## Description

The present invention is generally directed to a method and apparatus for laminating a polymer film over the surface of an irregular substrate, for example, a substrate on which a plurality of integrated circuit chips are affixed. The present invention relates for example to a packaging method for electronic integrated circuit chips, particularly very large scale integrated (VLSI) devices. Moreover, embodiments of the method and apparatus of the present invention provide a polymer film overlay for not only retaining "microchips" on a substrate, but also provides a means for interconnecting these devices. Even more importantly, the embodiments of the method and apparatus of the present invention provide removable interconnection capabilities.

JP-A-59104907 discloses an apparatus for applying a film to an irregular workpiece, said apparatus comprising a substantially flat substrate holder assembly for supporting said workpiece and said film over said workpiece; a chamber mounted at a first surface of said holder assembly; means to apply vacuum conditions to a volume bounded by said holder assembly and said film; and means to heat said film.

DE-A-2915923 discloses an apparatus in which a pervious object is placed on a car which is moved into a coating chamber. In the chamber, a vacuum is applied to a mold and the object is sucked into the mold. A coating film is heated in the chamber and the mold is moved towards the film so it too is sucked by the vacuum onto the pervious object, whereby the object is coated. The coated object is heated to ensure good bonding of the coating thereto.

In the packaging of very large scale integrated circuit devices, a great deal of space is taken up by mechanisms for interconnecting one chip to an adjacent device. This makes the pacakging of integrated circuit devices and electronic components based thereon larger than necessary. As a result of this, many individuals are involved in the development of so-called wafer-scale integration processes. However, the efforts expended in these directions have generally tended to be limited by the problem of yield. Because a certain number of chips or dies on a wafer are often found to be defective, the number of wafers that are produced that are completely usable is generally lower than is desired. Furthermore, there still exists the problem of interconnecting the various chips on a wafer and the concomitant problem of testing a large system, such as results when a number of highly complicated individual integrated circuit components are interconnected. Accordingly, it is seen that it would be very desirable to be able to construct wafer scale integrated circuit packages from individual, easily testable integrated circuit chips. It is to this end that the present invention is directed.

One of the generic problems sought to be solved by the system of the present invention is the laminating of a polymer film to an irregular surface. Certain laminating methods suffer from several deficiencies that become extremely important when one is trying to dispose film material on integrated circuit devices. This is particularly true in those circumstances in which passivation layers have not yet been applied to such devices. One method of continuous lamination is so-called roll lamination in which a substrate to be laminated is passed between two heated rollers and the pinching effect of the rollers, combined with heat, laminates the film to the substrate. Several problems exist in this approach. The approach is adequate if the substrate is perfectly fiat. However, the rollers cannot comply to an irregular surface, with the result being a poor lamination in low spots and overpressure effects in high spots. Also, a substrate with an irregular surface on the bottom side would damage the lower roller or the substrate. For example, pins coming down from the bottom of a package would be damaged. Another problem with roll lamination occurs when high temperatures are required to process high temperature adhesives. Compliant materials are not available with high temperature capabilities. Silicone materials seem to be the best known compliant substances for this purpose. However, this material tends to revert to a sticky goo at temperatures around 200°C. A third problem also exists with this methodology since it is necessary that the top roll touch the material to be laminated. It is impossible then to prevent contamination from the top roll from also contaminating the surface of the polymer being laminated. This problem is especially serious with rollers comprising silicone material. Silicone materials produce outgassing products which contaminate the top surface and prevent good adhesion when subsequent layers are applied to the top surface of the film being laminated.

A second method used in laminating involves the use of a vacuum bag. In this system, a bag formed of high temperature material is placed around the materials to be laminated. The bag is evacuated and the bag placed in an oven. There are several problems associated with the vacuum bag methodology, however. One problem is that it is not a continuous process. That is, material to be laminated must be placed in the bag, the bag evacuated, the bag placed in an oven for a period of time, and after lamination, the laminated piece is removed from the bag. Automatic feed of material is therefore precluded. The second problem with vacuum bag methodologies is that the pressure is limited to the outside air pressure, even in the face of a perfect vacuum. Still another problem with this method is that the vacuum bag does touch the top of the material being laminated. Contamination from the bag can then be transferred to the material being laminated.

A third laminating method is the standard press lamination. In this method, the material to be laminated is placed between two heated platens which are forced together by means such as a hydraulic jack. This technique works if the materials to be laminated are flat. If the substrate to be laminated is irregular in shape, or if there are small particles on the surface of the substrate to be laminated, very high pressures where the particles are present will punch through the film to be laminated and no pressure is available at the low points on the substrate. The thinner the film, the greater this problem becomes. A partial solution to this problem is the use of compliant pads to absorb some of the pressure differential. However, compliant pads contaminate the top surface of the film to be laminated and, in high temperature situations, there are no suitable compliant pad materials available. An additional problem of press laminating is that it takes time and energy to cool and heat the relatively high thermal mass platens. The platens must be physically thick structures because they are required to take high pressures over a large area without bending. An additional problem with press laminating is the removal of air and by products of the heating of adhesives during the lamination process, since the pressure tends to trap air and byproducts and tends to form blisters.

Additional problems occur when the film to be laminated to a substrate is a thermoplastic. Unless the top press pad has a special release property, the thermoplastic often will stick as well to the top press pad as it does to the substrate. Another problem exists in that no compliant pad can provide the dual function of maintaining constant pressure on the thermoplastic film at the same time that it perfectly matches the contour of the underlaying substrate. Accordingly, it is seen that certain laminating methodologies are inappropriate for use in facilitating the construction of wafer scale integrated circuit devices, as contemplated herein.

In accordance with one aspect of the present invention there is provided an apparatus for applying a polymer film to an irregular workpiece said apparatus comprising: a substantially flat workpiece holder assembly for supporting said workpiece and said polymer film over said workpiece; a first chamber for containing the holder assembly; means to apply vacuum conditions to a volume bounded by said holder assembly, and said polymer film; means to heat said film characterized in that the first chamber is movable to seal against a first surface of said holder assembly and said polymer film; a film riser is disposed on said first surface of said holder assembly so as to support said film over but not in substantial contract with said workpiece; and said means to apply vacuum conditions includes a second chamber sealable against the second surface of said holder assembly at a point thereon opposite said film riser, the volume defined by said second chamber and said holder assembly being in flow communication with the volume defined at least by said polymer film and said holder assembly.

In accordance with another aspect, there is provided a method for applying a polymer film to an irregularly-shaped workpiece, said method comprising: placing said workpiece on a workpiece holder assembly; disposing a film riser on said holder assembly; disposing said film over said workpiece, whereby said film riser supports said film over but not in substantial contact with said workpiece; applying vacuum conditions above and below said film so as to maintain said non-contact condition; heating said film, while maintaining said vacuum conditions so as to remove outgassing products; and applying fluid pressure conditions above said film so as to force said film into contact with said workpiece.

The workpiece is irregular because, for example, it has disposed thereon one, or a plurality of, integrated circuit chip dies. These dies may even represent integrated circuit chips from different chip technologies such as silicon based chips and gallium arsenide based chips. Such chips are not limited to comprising only silicon based chips.

As used herein and in the appended claims "substantial contact" is that contact which would preclude the removal of air and/or gaseous products.

As used herein and in the appended claims, the term "chamber" does not refer to a void, but rather to means for defining an enclosed volume.

The invention, however, both as to organization and method of practice, may be better understood by reference to the following description taken in connection with the accompanying drawings in which:
Figure 1 is a partial cross-sectional side elevation view of an apparatus in accordance with the present invention;
Figure 2A is a cross-sectional side elevation schematic view showing detail from a portion of Figure 1 and more particularly illustrating the relationship of the polymer film and the substrate to be laminated prior to contact;
Figure 2B is a view similar to Figure 2A except that the film is now shown in contact with and complying to the surface of the substrate;
Figure 3A is a view more particularly illustrating the use of separate lamination films and sealing films;
Figure 3B is a cross-sectional side elevation view showing a detailed view of the layered structures in Figure 3A;
Figure 3C is a view similar to Figure 3A, but more particularly showing the utilization of a thermoplastic laminating film and a release sealing layer;
Figure 3D is a cross-sectional side elevation view showing a detailed portion of the layer structure in Figure 3C;
Figure 3E is a view similar to Figure 3A, but more particularly showing the utilization of a thermoplastic laminating film with a thin metal deposit thereon for release;
Figure 3F is a cross-sectional side elevation view showing a detailed portion of the the layered structure in Figure 3E;
Figure 3G is a view similar to Figure 3A more particularly illustrating a method for laminating a dry film resist;
Figure 3H is a cross-sectional side elevation view more showing a detailed portion of the layered structure of Figure 3G;
Figure 4A is a view illustrating the use of a metal foil as release mechanism, particularly for use with thermoplastic films;
Figure 4B is a view similar to Figure 4A, but more particularly including an aperture in the metal foil for facilitating the heating of substrate 33;
Figure 5 is a cross-sectional side elevation view particularly illustrating the utilization of cooling means to prevent thermoplastic melting except over the substrate;
Figure 6 is a partial cross-sectional side elevation view similar to Figure 1 more particularly illustrating an apparatus with continuous roll-to-roll capability.

### Detailed Description of the Invention

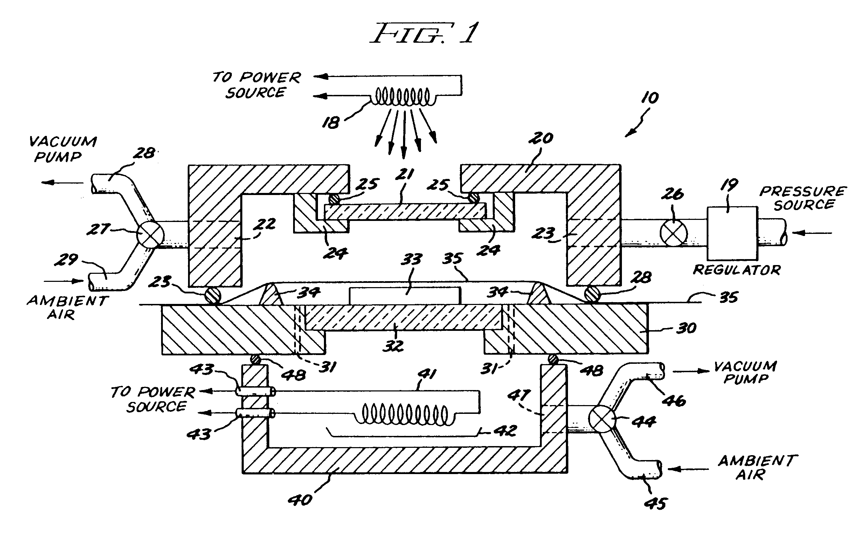

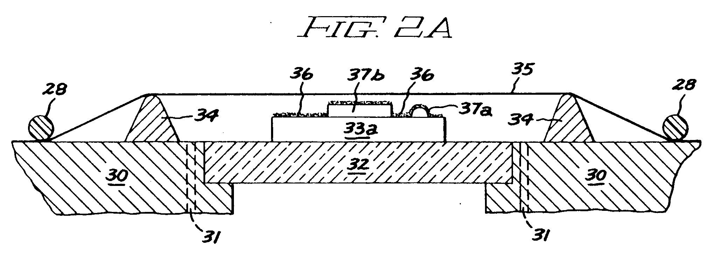

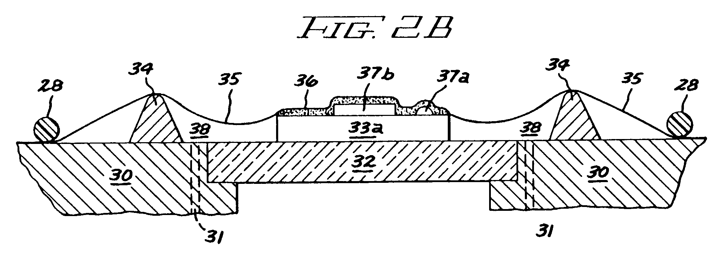

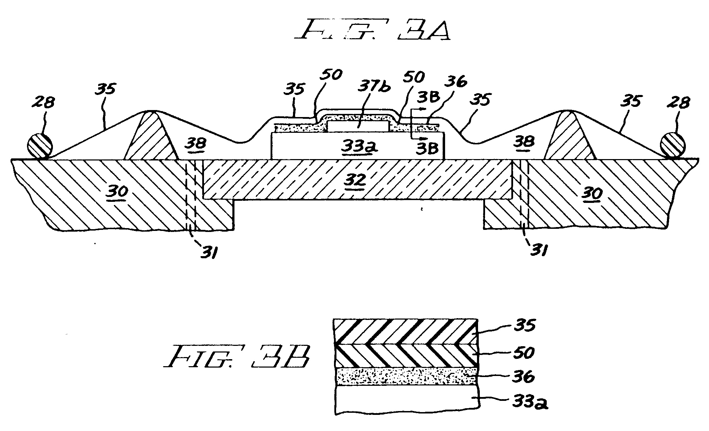

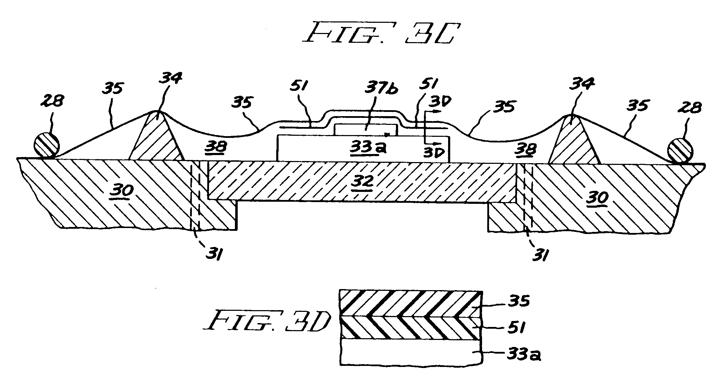

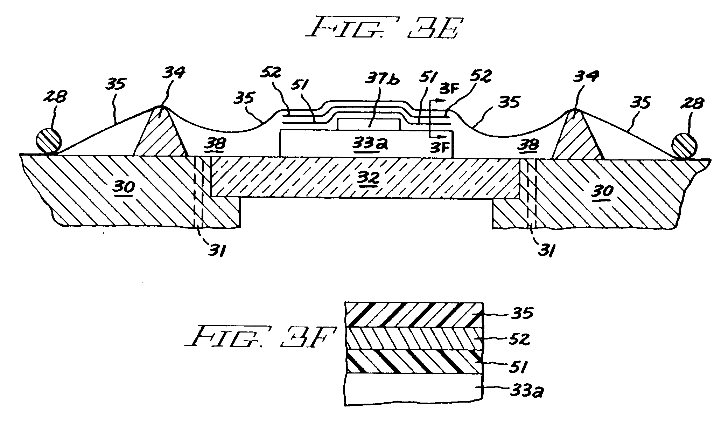

Figure 1 shows a cross-sectional diagram illustrating the basic components of an apparatus 10 in accordance with a preferred embodiment of the present invention. The components of the apparatus include substrate holder 30 upon which workpiece 33 is positioned for processing. Substrate holder assembly 30 preferably includes infrared transmissive window 32 disposed in a recess in a holder assembly. Window 32 preferably comprises a low thermal mass. Substrate holder assembly 30 also includes fluid ports 31 for producing vacuum conditions beneath film (or seal material) 35. Also, substrate holder assembly 30 includes film riser 34 disposed on the holder assembly so as to support film 35 above workpiece 33 so that contact between the film and the workpiece does not occur until desired.

The apparatus of Figure 1 also includes upper, movable chamber 20 which is sealable against holder assembly 20 and the polymer film by means of gasket or seal 28. Upper chamber assembly 20 includes means for producing both vacuum and pressure conditions above the polymer film. In particular, upper chamber 20 includes flow conduit 22 connected to three-way valve 27 which is selectable to connect upper chamber 20 to a vacuum pump through conduit 28 or to ambient atmospheric pressure conditions through conduit 29. Upper chamber 20 also includes flow conduit 23 connected to pressure regulator 19 through valve 26. This provides a means for applying fluid pressure above polymer film 35 when movable chamber 20 is positioned so as to be sealed against polymer film 35 and substrate holder assembly 30 (as shown). Upper chamber 20 also preferably includes infrared transmissive window 21 disposed so as to be sealably affixed as shown, using gasket or seal 25 and retention assembly 24. Also preferably included is radiant infrared energy heat source 18 which is disposed above window 21 and provided to heat film 35 and workpiece 33 from above.

In a similar manner, lower chamber 40 is provided beneath window 32 and is structured so as to be sealably affixed to holder assembly 30, as for example, by seals or gaskets 48. Lower chamber 40 is designed to maintain either ambient atmospheric pressure or vacuum conditions. Lower chamber 40 also preferably includes heater 41 together with infrared reflector 42 which is positioned so as to direct radiant infrared energy through infrared transmissive window 32 so as to heat workpiece 33 and film 35 from below. Heater 41 is preferably electrically powered, as for example, from feedthroughs 43. Lower chamber 40 also includes flow conduit 47 which is connected to three-way valve 44. This valve is selectable so as to connect the volume of lower chamber 40 with vacuum conditions through conduit 46, or to ambient air conditions as through conduit 45.

Apparatus 10 shown in Figure 1 is generally operable in the following manner to produce the result desired. In operation, a workpiece 33 is placed on substrate holder assembly 30 and the workpiece is covered (but not contacted) by the polymer film to be laminated. In one exemplary embodiment, the workpiece is precoated with a thermoplastic adhesive. Upper chamber 20 is then forced into intimate contact with polymer film 35 and substrate holder assembly 30. This forms a seal on one side between the polymer film and the upper pressure chamber assembly, and on the other side between the polymer film and the substrate holder assembly. Particular attention is now directed to vacuum ports 31 in substrate holder assembly 30. When vacuum is drawn through these ports, through lower chamber 40, a vacuum is formed throughout the the volume under the polymer film up to the point where the polymer film seals with the substrate holder assembly. This vacuum removes air from between the polymer film and the workpiece and allows intimate contact therewith. Generally, however, vacuum conditions may also be applied simultaneously to the upper chamber assembly 20 to keep the film from sealing irregular areas on the substrate and preventing the lower vacuum from removing all gas from between the polymer film and the workpiece. Film risers 34 are important during this phase to keep the film from touching the workpiece. This is especially important when adhesive on the workpiece becomes tacky. On subsequent heating, the vacuum removes outgassing products generated by the heating of any adhesive, the polymer film, and the workpiece. After suitable outgassing, pressure is applied to the top of the polymer film by admitting gas or other fluid to the upper chamber assembly. A uniform pressure is now applied to the polymer film throughout the volume of the upper chamber assembly out to the point where the chamber assembly seals to the polymer film. The gas admitted to the pressure chamber assembly cannot escape because of the seal between the pressure chamber and the polymer film. Heating of the substrate may be achieved in several different ways. In the preferred embodiment, the workpiece is placed on transparent window 32. This allows infrared radiation from lower heater element 41 to impinge directly on workpiece 33 and to thereby heat the workpiece with very little heating of the window assembly. In addition, a window is preferably placed in the upper pressure assembly and additional radiative energy is applied to the polymer film from above and, through the polymer film, to the workpiece itself. Very rapid heating of the substrate is achieved because of the low thermal mass of the supporting structure. Note also that hot gas or even a hot liquid can be admitted through inlet 23 of the pressure chamber to provide for very rapid heating on the surface of the polymer film. In addition, cooling can be effected by supplying a cooling gas and providing a flow through an outlet port of the upper chamber assembly such that pressure is maintained on the polymer film while a flow of cooling gas rapidly cools the film and the substrate.

In accordance with a preferred embodiment of the present invention, the method and apparatus disclosed herein is particularly adapted to the situation in which workpiece 33 includes a substrate on which there is disposed a plurality of integrated circuit chips. These chips may be affixed to the substrate by any suitable adhesive means. Accordingly, in accordance with the present invention, the resultant product comprises a substrate containing a plurality of integrated circuit chips covered by a thin polymer film in which apertures may be formed and on which conductive patterns may be disposed so as to interconnect the integrated circuit chips. In accordance with preferred embodiments of the present invention, the substrate on which the chips are disposed preferably comprises a material such as ceramic. However, usable substrates also include metals, glass, plastics, and composites. It is also a significant feature of the present invention that the polymer film disposed over integrated circuits as described above is removable and thereby provides a mechanism for reconfiguration and independent testing of integrated circuit chips.

It should be appreciated that the method and apparatus described above solves many of the significant problems associated with trying to fabricate such integrated circuit. In particular, it is seen that the apparatus and method described herein alleviate problems associated with high temperature processing and also problems associated with disposing films on irregularly shaped surfaces such as those defined by a plurality of integrated circuit chips disposed on an underlying substrate. It also alleviates the problem of removing outgassing products.

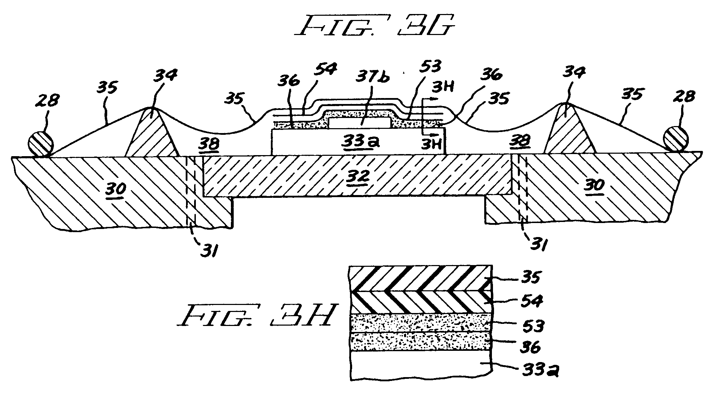

Figure 2A is an enlargement of a portion of the view shown in Figure 1. More particularly, Figure 2A illustrates the conditions present before contact is made between film 35 and workpiece 33 shown herein in more detail. In particular, workpiece 33 includes substrate 33a on which is affixed integrated circuit chip 37b. Also shown present on substrate 33a is undesired particle 37a, shown here only for purposes of illustration. A coating of adhesive 36 is also shown over substrate 33a and chip 37b. Polymer film 35 is seen disposed above but not in contact with either the workpiece or the adhesive. In this condition, intimate contact with the substrate has not yet been achieved so that air and outgassing products are drawn out so that they do not form blisters in the final laminate structure. This also removes undesirable contaminants from the surface of the chip. After heating for a period of time, the adhesive melts and pressure is applied to the top surface of film 35, as described above. The resulting condition is shown schematically in Figure 2B. Note that the polymer film now complies accurately to the shape of the irregular substrate. Note also that the polymer film complies to the shape of particle 37a. It is important to point out here that the particle, while undesired, is effectively covered by the polymer film without the very sharp particle punching through the polymer film. In the case of compliant pads or rollers, a very high pressure gradient would be produced around the area of the particle with a danger that the particle would punch through the thin polymer film. In the present invention, the pressure on all areas of the polymer film is the same and comes from a pressurized gas or liquid. This forces the best possible compliance to an irregularly shaped substrate, but yet prevents undue pressure gradients on edges and sharp particles. In addition to evacuating the area between the polymer and the workpiece, intimate, void-free contact from polymer to substrate is assured.

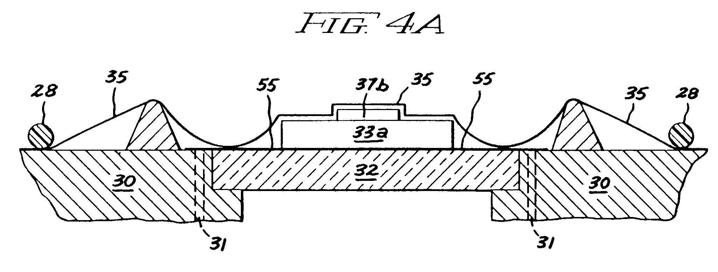

Figures 3A and 3B illustrate alternate embodiments of the present invention and in particular, alternate combinations of polymer film and workpiece which can be handled by the apparatus shown in Figure 1. In particular, Figure 3A shows a situation in which adhesive 36 coats an irregular workpiece. Film 50, to be bonded to the workpiece, is placed over it with second sealing film 35 actually forming the seal between the vacuum and pressure areas of the structure. This configuration is advantageous for laminating small pieces of film to a substrate. It is also advantageous where a large continuous film might not be practical. For example, when the film to be bonded is very thin and could not support reliably the high pressures of the process without the possibility of punch-through, the configuration of Figure 3A is desirable. This configuration is also advantageous where the film to be bonded does not completely cover the substrate. This case occurs when a repair or interconnect patch is being added to a substrate. Figure 3B provides a more detailed view of the layered structures shown schematically in Figure 3A.

The adhesive shown in Figure 2 or Figure 3A can either be a thermoplastic, a thermoset, or an ultraviolet curable adhesive. Examples of curing conditions for each type adhesive are now considered. For example, when using a thermoplastic adhesive such as ULTEM®, the workpiece is preferably heated to a temperature of 260°C under vacuum for three minutes, after which a pressure of approximately 2.1Kg/cm² (30 pounds per square inch) is applied and cooling is started immediately. When using an acrylic adhesive, it is preferable to heat the workpiece to a temperature of approximately 200°C under vacuum condition for three minutes and to then apply pressure of approximately 2.1Kg/cm² (30 pounds per square inch) holding the temperature and pressure constant for approximately 30 minutes before beginning cooling. In the case of an ultraviolet curable epoxy adhesive, the workpiece and adhesive is heated to a temperature of approximately 40°C under vacuum conditions for 20 seconds after which a pressure of approximately 2.1Kg/cm² (30 pounds per square inch) is applied. The material is irradiated with 7.9W/mm (200W/in) from a Hanovia uv lamp moved slowly back and forth across the substrate to provide uniform coverage. The epoxy is exposed for 5 to 10 seconds and the pressure is released.

An alternate embodiment of the present invention is illustrated in Figures 3C and 3D. In this case, a thermoplastic film 51 is laminated directly to the workpiece. Here, thermoplastic film 51 is covered by a film 35 which now acts as a release film and which actually provides the seal between the vacuum and pressure areas. Substantial flow of the thermoplastic film can be accommodated because release film 35 complies with the substrate, but does not flow. An example in accordance with this embodiment employs a polysulfone film such as 2.54x10⁻²mm (1 mil) thick UDEL™ film made by Union Carbide. This film is heated to a temperature of approximately 250°C in vacuum and a pressure of approximately 1.4Kg/cm⁻² (20 pounds per square inch) is thereafter applied following which slow cooling is initiated after about one minute at 250°C. Figure 3D provides a more detailed view of the layered structures shown schematically in Figure 3C.

Figures 3E and 3F show another embodiment of the present invention. In cases where thermoplastic material 51 adheres well to the overlying release film 35, metal layer 52 can be deposited on the thermoplastic before the laminating cycle. Here thin metal layer 52 prevents thermoplastic 51 from actually contacting overlying laminating layer 35 and thereby prevents adhesion between thermoplastic 51 and overlying layer 35. For example, in this embodiment, a 10⁻⁴mm (1,000 angstrom) thick layer of chromium, together with a 2.5x10⁻⁴mm (2,500 angstrom) thick layer of aluminum may be deposited on a polysulfone film. See Figure 3F for a detailed view of the layered structure shown in Figure 3E.

In yet another embodiment of the present invention, it is possible to laminate a dry film photoresist using the method and apparatus of the present invention. For example, dry film photoresist such as RISTON™ (as supplied by Dupont de Nemours Company, Inc.) consists of three primary layers: MYLAR™ carrier layer 54, resist layer 53 and an adhesive layer 36. The material is designed to be laminated in a roll laminator. However, if an irregular substrate is encountered, the dry film resist can be laminated as shown in Figure 3G using the apparatus of Figure 1. For this film, a temperature of 100°C for a period of approximately one minute, with a pressure of approximately 2.1Kg/cm² (30 pounds per square inch) is sufficient to give very adherent, well-complied photoresist coverage. The carrier layer 54 can also be used as the seal layer 35 in yet another embodiment. See also Figure 3H for a detailed view of the layer structure.

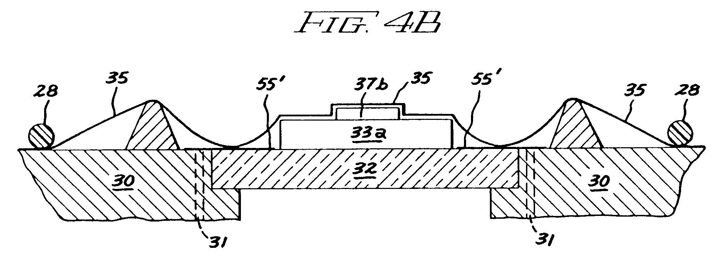

It is also possible to employ a thermoplastic film as the film which also forms the seal between the vacuum and pressure regions. Figures 4A and 4B illustrate two embodiments of the present invention which permits this kind of lamination. In Figure 4A, metal foil 55, such as aluminum, is placed under the workpiece and continues out to the sealing regions. Thermoplastic film 35 covers the workpiece. On subsequent heating, thermoplastic film 35 softens and adheres both to the substrate and to metal foil 55. If the foil were not placed under the substrate and out to the sealing regions, the thermoplastic material would tend to stick to the substrate holder assembly and not allow removal of the substrate. This is undesirable. Figure 4B illustrates an alternate embodiment of this procedure in which metal foil 55' possesses a cutout or cutouts to accommodate the substrate and to also thereby allow radiant energy to impinge directly on the substrate from below and so as to thereby heat the workpiece more efficiently.

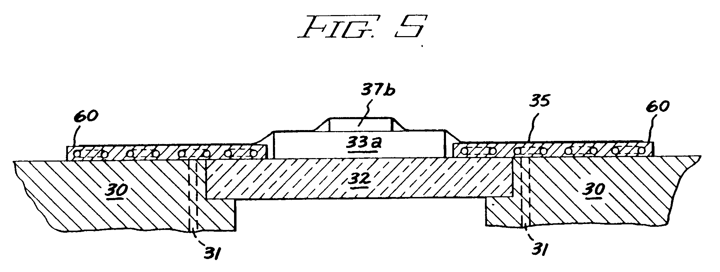

Figure 5 illustrates yet another embodiment of the present invention in which a cooled copper insert 60 is provided around the workpiece to prevent the melting of the thermoplastic layer beyond the edges of the workpiece and to thereby prevent adhesion of the thermoplastic to the substrate holder assembly.

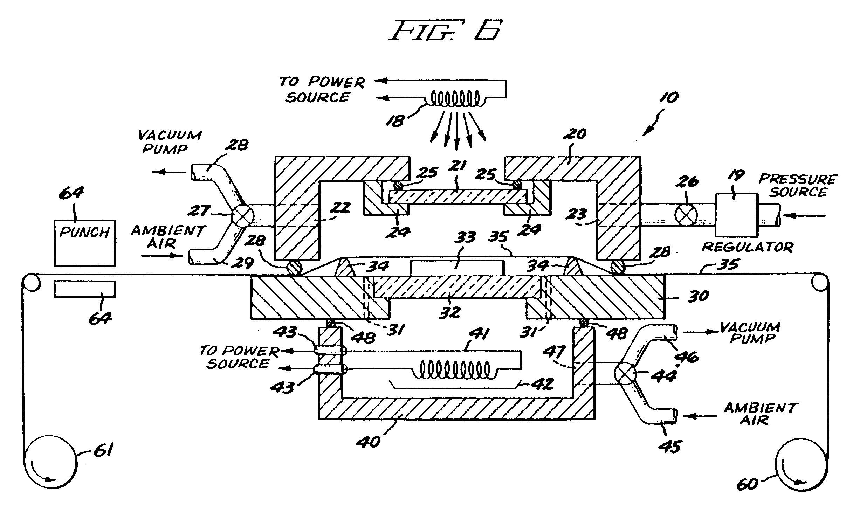

Figure 6 illustrates yet another embodiment of the present invention and particularly shows a side view of the basic pressure laminator of Figure 1 adapted for roll-to-roll processing. In this system, adhesive coated work-pieces, such as 33, are fed at right angles to the direction of motion of polymer film 35. As each new substrate is positioned on the substrate holder assembly, the pressure chamber assembly is forced over the polymer film, thereby making a seal for both the vacuum section and the pressure section. The evacuating, pressurizing, heating, application of radiant energy and cooling by gas flow, as required for the process, take place as described above. When the substrate is sufficiently cooled, the pressure chamber is retracted and the polymer film is rolled from supply reel 65 to such a position that the laminated substrate moves from right to left with a new film transported into the laminating position and a new substrate is positioned in the substrate holder assembly. At this point, the process can be repeated. Substrates are either rolled up on the takeup roll or punched out of the center of the film by punch 64. The process can also be adapted to incorporate film cleaning and inspection apparatus so that defective portions of the film can be bypassed simply by continuing the rolling process until the film overlying the substrate is free of defects. Throughout the discussion thus far, the adhesive has been described as being present on the substrate. It is equally possible to apply the adhesive directly to the polymer film. A suitable process in which adhesives are applied to the film is now presented. For example, one side of a KAPTON™ polyimide film as supplied by Dupont de Nemours Company, Inc. is etched for 6 minutes at 300 watts in a gas Comprising 50% CF₄ and 50% oxygen at a pressure of 0.4 torr in a barrel plasma etcher. A solution of 26 gram ULTEM® (as supplied by the General Electric Company) resin, 104 grams of methylene chloride and 155 grams acetophenone is sprayed on the etched KAPTON™ film. The etched and sprayed film is dried at a temperature of approximately 180°C for three minutes, after which it is baked at a temperature of 350°C for approximately five minutes.

It is noted that the apparatus and method described herein provides an extremely convenient, economical and facile mechanism for covering integrated circuit chips which are disposed on an underlying substrate. The presence of the circuit chips provides one of the most significant of the irregularly shaped surfaces contemplated herein. It is noted, however, that the advantages of the present invention are nonetheless obtainable even when only a single chip is covered in accordance with the present invention. In particular, apertures are provided in the polymer film, as by laser methods such as described in concurrently filed application Serial No. (RD-17,428) titled "Method to Produce Via Holes in Polymer Dielectrics for Multiple Electronic Circuit Chip Packaging". This application, assigned to the same assignee as the present invention, is hereby incorporated herein. A layer of metallization may then be deposited and patterned so as to provide interconnections between various interconnection pads on the circuit chips. In this way, connections can be made to different parts of the same chip or between chips. A significant advantage of the present invention is that the polymer film is removable. This provides a mechanism for testing and later reconfiguration. A multichip integrated circuit packaging configuration and method in accordance with the present invention is disclosed in concurrently filed application No. 87906695.7 (RD-17432), also assigned to the same assignee as the present invention. This patent application is also hereby incorporated herein by reference.

From the above, it should be appreciated that the above-described illustrative method and apparatus of the present invention provide significant advantages in the packaging of electronic circuit chip components. In particular, it is seen that the method and apparatus provide a means for constructing wafer scale integrated circuit chip devices in an independent fashion enabling testing and reconfiguration of the devices. Most importantly, it is seen that the method of film deposition of the present invention alleviates problems associated with high temperature compliance of films to irregular surfaces. It is also seen that the film of the present invention can be removed from the devices, such as by disposing the resultant product in a suitable solvent such as methylene chloride.

While the invention has been described in detail herein in accord with certain preferred embodiments thereof, many modifications and changes therein may be effected by those skilled in the art.

An embodiment of the present invention may allow heating of the substrate from the bottom as well as heating from the top and may allow the application of ultraviolet radiation for the purpose of curing photosensitive material through a polymer layer.

Another embodiment of the present invention may provide a method of laminating thermoplastic layers which accurately follow the contours of an irregular substrate and which does not need a release layer covering a thermoplastic film.

Another embodiment of the invention may provide a device without high thermal mass platens so that heating can be accomplished by infrared energy impinging directly on the surface and where fast cooling can be achieved by allowing a flow of gas or other coolant fluid over the top surface of the film being laminated while still maintaining pressure on the film.

A still further embodiment of the present invention may provide a device in which special processing gasses can be admitted either between the substrate and the laminating film or above the laminating film.

## Claims

1. An apparatus for applying a polymer film (35) to an irregular workpiece (33) said apparatus comprising:
a substantially flat workpiece holder assembly (30) for supporting said workpiece (33) and said polymer film over said workpiece;
a first chamber (20) for containing the holder assembly;
means to apply vacuum conditions (22,27,29,40,44,45, 46) to a volume bounded by said holder assembly, and said polymer film;
means to heat (18,21,41) said film characterized in that the first chamber is movable to (20) seal against a first surface of said holder assembly and said polymer film;
a film riser (34) is disposed on said first surface of said holder assembly so as to support said film (35) over but not in substantial contact with said workpiece (33); and
said means to apply vacuum conditions includes a second chamber (40) sealable against the second surface of said holder assembly at a point thereon opposite said film riser, the volume defined by said second chamber and said holder assembly being in flow communication with the volume defined at least by said polymer film and said holder assembly.

2. The apparatus of claim 1 in which said means for heating includes an infrared transparent window (21) in said movable chamber.

3. The apparatus of claim 1 or 2 in which said means for heating said film includes a heater (41) disposed within said second chamber.

4. The apparatus of claim 1, 2 or 3 in which said holder assembly includes an infrared transparent window 32) on which said workpiece is disposable.

5. The apparatus of claim 1, 2, 3 or 4 in which said holder assembly (30) includes a low thermal mass portion on which said workpiece is disposable.

6. The apparatus of claim 1 further including substantially flat coolable inserts (60) disposed on said holder assembly (30) so as to form a recess in which said workpiece is disposable.

7. Apparatus according to any one of claims 1 to 6 wherein the workpiece comprises at least one circuit chip.

8. A method for applying a polymer film (35,51) to an irregularly-shaped workpiece (33), said method comprising:
placing said workpiece (33) on a workpiece holder assembly (20);
disposing a film riser (34) on said holder assembly (20);
disposing said film (35) over said workpiece (33) whereby said film riser (34) supports said film over but not in substantial contact with said workpiece (33);
applying vacuum conditions above and below said film while maintaining said non-contact condition;
heating said film, while maintaining said vacuum conditions so as to remove outgassing products; and
applying fluid pressure conditions above said film so as to force said film into contact with said workpiece.

9. The method of claim 8 further including disposing an adhesive (36) between said film and said workpiece prior to disposing said film over said workpiece.

10. The method of claim 9 in which said adhesive comprises thermoplastic material.

11. The method of claim 9 in which said adhesive comprises thermoset material.

12. The method of claim 9 in which said adhesive comprises an ultraviolet curable material.

13. The method of claim 8 in which said film is a thermoplastic material (51) and further includes the step of disposing a release layer (35) over said thermoplastic film and in which said pressure conditions are applied over said release layer.

14. The method of claim 13 in which said film is thermoplastic (51) and includes a metal release layer (52) disposed thereon.

15. the method of claim 8 in which said polymer film includes a carrier layer (54), a photoresist layer (53) and an adhesive layer 36 respectively, said adhesive layer being disposed closest to said workpiece and in which a release layer 35 is disposed over said carrier layer.

16. The method of claim 8, further including the step of cooling said polymer film in the region surrounding said workpiece.

17. The method of claim 8 further including disposing a release film (55) beneath said workpiece.

18. The method of claim 17 in which said release film comprises a metal foil.

19. the method of claim 18 in which said metal foil comprises aluminum.

20. The method of claim 8 further including the step of providing at least one aperture in said release film for heating said workpiece from beneath.

21. A method according to any one of claims 8 to 19 wherein the workpiece comprises at least one circuit chip.

## Patentansprüche

1. Einrichtung zum Aufbringen eines Polymerfilms (35) auf ein unregelmäßiges Werkstück (33), wobei die Einrichtung enthält:
eine im wesentlichen ebene Werkstückhalteanordnung (30) zum Haltern des Werkstückes (33) und des Polymerfilms über dem Werkstück,
eine erste Kammer (20), die die Halteanordnung enthält,
eine Einrichtung (22, 27, 29, 40, 44, 45, 46) zum Herstellen von Vakuumbedingungen in einem Volumen, das durch die Halteanordnung und den Polymerfilmen begrenzt wird,
eine Heizeinrichtung (18, 21, 41) zum Erhitzen des Films, dadurch gekennzeichnet, daß die erste Kammer (20) bewegbar ist zum Ausbilden einer Abdichtung gegen die erste Oberfläche der Halteanordnung und des Polymerfilms,
einen Filmheber (34), der auf der ersten Oberfläche der Halteanordnung angeordnet ist, um den Film (35) über, aber nicht in einem wesentlichen Kontakt mit dem Werkstück (33) zu halten, wobei die Einrichtung zum Herstellen von Vakuumbedingungen eine zweite Kammer (40) aufweist, die gegen die zweite Oberfläche der Halteanordnung auf einem Punkt darauf abdichtbar ist, der dem Filmheber gegenüberliegt, wobei das Volumen, das durch die zweite Kammer und die Halteanordnung gebildet ist, in Strömungsverbindung mit dem Volumen ist, das wenigstens durch den Polymerfilm und die Halteanordnung gebildet ist.

2. Einrichtung nach Anspruch 1, wobei die Heizeinrichtung ein für Infarotstrahlung transparentes Fenster (21) in der bewegbaren Kammer aufweist.

3. Einrichtung nach Anspruch 1 oder 2, wobei die Heizeinrichtung zum Erhitzen des Films eine Heizvorrichtung (41) aufweist, die in der zweiten Kammer angeordnet ist.

4. Einrichtung nach Anspruch 1, 2 oder 3, wobei die Halteeinrichtung ein für Infarotstrahlung transparentes Fenster (32) aufweist, auf dem das Werkstück angeordnet werden kann.

5. Einrichtung nach Anspruch 1, 2, 3 oder 4, wobei die Halteeinrichtung (30) einen Abschnitt mit kleiner thermischer Masse aufweist, auf dem das Werkstück angeordnet werden kann.

6. Einrichtung nach Anspruch 1, wobei ferner im wesentlichen ebene kühlbare Einsätze (60) vorgesehen sind, die auf der Halteeinrichtung (30) derart angeordnet sind, daß eine Vertiefung ausgebildet, in der das Werkstück angeordnet werden kann.

7. Einrichtung nach einem der Ansprüche 1 bis 6, wobei das Werkstück wenigstens ein Schaltungschip aufweist.

8. Verfahren zum Aufbringen eines Polymerfilms (35, 51) auf ein unregelmäßig geformtes Werkstück (33), wobei das Verfahren entält:
Anordnen des Werkstückes (33) auf einer Werkstückhalteanordnung (20),
Anordnen eines Filmhebers (34) auf der Halteanordnung (20),
Anordnen des Films (35) über dem Werkstück (33) derart, daß der Filmheber (34) den Film über, aber nicht in einem wesentlichen Kontakt mit dem Werkstück (33) haltert,
Herstellen von Vakuumbedingungen oberhalb und unterhalb des Films, während der Nicht-Kontakt-Zustand beibehalten wird,
Erhitzen des Films, während die Vakuumbedingungen beibehalten werden, um so Entgasungsprodukte abzuführen, und
Herstellen von Fluiddruckbedingungen oberhalb des Films, um so den Film in einen Kontakt mit dem Werkstück zu drücken.

9. Verfahren nach Anspruch 8, wobei ferner ein Kleber (36) zwischen dem Film und dem Werkstück angeordnet wird, bevor der Film über dem Werkstück angeordnet wird.

10. Verfahren nach Anspruch 9, wobei der Kleber thermoplastisches Material aufweist.

11. Verfahren nach Anspruch 9, wobei der Kleber wärmehärtbares Material aufweist.

12. Verfahren nach Anspruch 9, wobei der Kleber ein durch Ultraviolletstrahlung härtbares Material aufweist.

13. Verfahren nach Anspruch 8, wobei der Film ein thermoplastisches Material (51) ist und ferner eine Ablöseschicht (35) über dem thermoplastischen Film angeordnet wird und wobei die Druckbedingungen über der Ablöseschicht hergestellt werden.

14. Verfahren nach Anspruch 13, wobei der Film (51) thermoplastisch ist und eine metallische Ablöseschicht (52) aufweist, die darauf angeordnet ist.

15. Verfahren nach Anspruch 8, wobei der Polymerfilm eine Trägerschicht (54), eine Photolackschicht (53) und eine Kleberschicht (36) aufweist, wobei die Kleberschicht am nahesten an dem Werkstück angeordnet und die Ablöseschicht (35) über der Trägerschicht angeordnet wird.

16. Verfahren nach Anspruch 8, wobei der Polymerfilm in dem das Werkstück umgebenden Bereich gekühlt wird.

17. Verfahren nach Anspruch 8, wobei ein Ablösefilm (55) unterhalb des Werkstückes angeordnet wird.

18. Verfahren nach Anspruch 17, wobei der Ablösefilm eine Metallfolie aufweist.

19. Verfahren nach Anspruch 18, wobei die Metallfolie Aluminium aufweist.

20. Verfahren nach Anspruch 8, wobei wenigstens eine Öffnung in dem Ablösefilm ausgebildet wird, um das Werkstück von unten zu erwärmen.

21. Verfahren nach einem der Ansprüche 8 bis 19, wobei das Werkstück wenigstens einen Schaltungschip aufweist.

## Revendications

1. Appareil pour appliquer un film (35) polymère sur une pièce à travailler (33) de forme irrégulière, ledit appareil comprenant:
un assemblage (30) de maintien de pièce à travailler sensiblement plat, pour supporter ladite pièce à travailler (33) et ledit film polymère au-dessus de ladite pièce à travailler;
une première chambre (20) pour contenir l'assemblage de maintien;
des moyens (22, 27, 29, 40, 44, 45, 46) pour appliquer des conditions de vide à un volume délimité par ledit assemblage de maintien et ledit film polymère;
des moyens (18, 21, 41) pour chauffer ledit film, caractérisé en ce que la première chambre (20) est mobile pour pouvoir être appliquée de façon étanche contre une première surface dudit assemblage de maintien et ledit film polymère;
un support (34) surélévateur de film est disposé sur ladite première surface dudit assemblage de maintien de façon à supporter ledit film (35) au-dessus de ladite pièce à travailler (33) mais sans qu'il soit sensiblement en contact avec cette dernière; et
lesdits moyens d'application de conditions de vide comprennent une seconde chambre (40) apte à être appliquée de façon étanche contre la seconde surface dudit assemblage de maintien en un point de cette surface opposé audit support surélévateur de film, le volume défini par ladite seconde chambre et ledit assemblage de maintien étant en communication du point de vue fluide avec le volume défini au moins par ledit film polymère et ledit assemblage de maintien.

2. Appareil selon la revendication 1, dans lequel lesdits moyens de chauffage comprennent une fenêtre (21) laissant passer le rayonnement infrarouge, située dans ladite chambre mobile.

3. Appareil selon la revendication 1 ou la revendication 2, dans lequel lesdits moyens de chauffage dudit film comprennent un élément (41) chauffant disposé à l'intérieur de ladite seconde chambre.

4. Appareil selon l'une quelconque des revendications 1, 2 et 3, dans lequel ledit assemblage de maintien comprend une fenêtre (32) laissant passer le rayonnement infrarouge et sur laquelle peut être disposée ladite pièce à travailler.

5. Appareil selon l'une quelconque des revendications 1, 2, 3 et 4, dans lequel ledit assemblage (30) de maintien comprend une partie de faible masse thermique sur laquelle peut être disposée la pièce à travailler.

6. Appareil selon la revendication 1, comprenant en outre des éléments (60) rapportés sensiblement plats et aptes à être refroidis, disposés sur ledit assemblage (30) de maintien de façon à former un évidement dans lequel peut être disposée ladite pièce à travailler.

7. Appareil selon l'une quelconque des revendications 1 à 6, dans lequel la pièce à travailler comprend au moins une puce à circuits.

8. Procédé d'application d'un film (35, 51) polymère sur une pièce à travailler (33) de forme irrégulière, ledit procédé consistant:
à placer ladite pièce à travailler (33) sur un assemblage (20) de maintien de pièce à travailler;
à disposer un support (34) surélévateur de film sur ledit assemblage (20) de maintien;
à disposer ledit film (35) au-dessus de ladite pièce à travailler (33) de façon à ce que ledit support (34) surélévateur de film supporte ledit film au-dessus de ladite pièce à travailler (33) mais sans qu'il soit sensiblement en contact avec elle;
à appliquer des conditions de vide au-dessus et au-dessous dudit film tout en maintenant ladite condition de non contact;
à chauffer ledit film, tout en maintenant lesdites conditions de vide de façon à éliminer les produits de dégazage; et
à appliquer des conditions de pression de fluide au-dessus dudit film de façon à forcer ledit film à se mettre en contact avec ladite pièce à travailler.

9. Procédé selon la revendication 8, consistant en outre à disposer un adhésif (36) entre ledit film et ladite pièce à travailler avant de disposer ledit film au-dessus de ladite pièce à travailler.

10. Procédé selon la revendication 9, dans lequel ledit adhésif se compose d'une matière thermoplastique.

11. Procédé selon la revendication 9, dans lequel ledit adhésif se compose d'une matière thermodurcissable.

12. Procédé selon la revendication 9, dans lequel ledit adhésif se compose d'une matière durcissable aux rayons ultraviolets.

13. Procédé selon la revendication 8, dans lequel ledit film est une matière (51) thermoplastique, ledit procédé comprenant en outre l'étape consistant à disposer une couche (35) de séparation au-dessus dudit film thermoplastique, lesdites conditions de pression étant appliquées au-dessus de ladite couche de séparation.

14. Procédé selon la revendication 13, dans lequel ledit film est une matière (51) thermoplastique et comprend une couche (52) de séparation en métal disposée sur lui.

15. Procédé selon la revendication 8, dans lequel ledit film polymère comprend une couche (54) support, une couche (53) de photorésist et une couche (36) d'adhésif, respectivement, ladite couche d'adhésif étant située le plus près de ladite pièce à travailler, une couche (35) de séparation étant disposée au-dessus de ladite couche support.

16. Procédé selon la revendication 8, comprenant en outre l'étape consistant à refroidir ledit film polymère dans la région entourant ladite pièce à travailler.

17. Procédé selon la revendication 8, consistant en outre à disposer un film (55) de séparation en dessous de ladite pièce à travailler.

18. Procédé selon la revendication 17, dans lequel ledit film de séparation se compose d'une feuille métallique.

19. Procédé selon la revendication 18, dans lequel ladite feuille métallique est en aluminium.

20. Procédé selon la revendication 8, comprenant en outre l'étape consistant à prévoir au moins une ouverture dans ledit film de séparation pour chauffer ladite pièce à travailler par en dessous.

21. Procédé selon l'une quelconque des revendications 8 à 19, dans lequel la pièce à travailler comprend au moins une puce à circuits.
